**Europäisches Patentamt**

**European Patent Office**

**Office européen des brevets**

(19)

(11) Veröffentlichungsnummer: **0 058 759**
**B1**

(12) # EUROPÄISCHE PATENTSCHRIFT

(45) Veröffentlichungstag der Patentschrift:
24.09.86

(21) Anmeldenummer: 81109260.0

(22) Anmeldetag: 29.10.81

(51) Int. Cl.⁴: **H 05 K 7/20,** H 05 K 3/44,
H 05 K 3/00

(54) Steuergerät in Modulbauweise.

(30) Priorität: 25.02.81 DE 3107067

(43) Veröffentlichungstag der Anmeldung:
01.09.82 Patentblatt 82/35

(45) Bekanntmachung des Hinweises auf die Patenterteilung:
24.09.86 Patentblatt 86/39

(84) Benannte Vertragsstaaten:
AT CH DE FR GB LI

(56) Entgegenhaltungen:
EP-A-0 019 546
DE-A-2 904 012
US-A-3 268 772
US-A-3 631 325

(73) Patentinhaber: Siemens Aktiengesellschaft Berlin
und München, Wittelsbacherplatz 2, D-8000
München 2 (DE)

(72) Erfinder: Wunderling, Wilfried, Eibenstrasse 24,
D-8502 Zirndorf (DE)
Erfinder: Fehm, Udo, Braunsbacher Strasse 20,
D-8510 Fürth/Bayern (DE)
Erfinder: Rieck, Norbert, Trübnerstrasse 14, D-8500
Nürnberg (DE)
Erfinder: Kugler, Peter, Habichtstrasse 7, D-8510
Fürth/Bayern (DE)
Erfinder: Lochner, Erwin, Adam- Kraft- Strasse 30,
D-8522 Herzogenaurach (DE)
Erfinder: Vogel, Jürgen, Tannenbergstrasse 11,
D-8500 Nürnberg (DE)

## Beschreibung

Die Erfindung bezieht sich auf ein Steuergerät in Modulbauweise mit Vorrichtungen zur Kühlung von die elektronischen Bauteile tragenden Metallkernleiterplatten, bei denen die Bauteile über elektrische Verbindungen mit einem auf einer Tragprofilplatte angeordneten elektrischen Leitungssystem verbindbar sind, der Kern als Zunge aus der Metallkernleiterplatte herausragt und diese Zunge zur Herstellung einer thermischen Verbindung in eine metallische, gut wärmeleitende Klemmvorrichtung steckbar ist, die ihrerseits auf der metallischen Tragprofilplatte angeordnet ist.

Mit diesem Oberbegriff wird auf eine Anordnung Bezug genommen, wie sie beispielsweise aus der US-PS 32 68 772 bekannt ist.

Ähnliche Steuergeräte sind ferner auch beispielsweise in der Siemens-Zeitschrift 1979, Seiten 133-136 oder in der DE-OS 29 04 012 näher beschrieben. Zum Schutz im rauhen Betrieb werden die Leiterplatten gegebenenfalls in metallischen Kapseln untergebracht. Zur Kühlung können dabei die Kapseln mit Lüftungsschlitzen versehen werden oder es können besonders viel Verlustleistung verbrauchende Elemente auch in geeigneter Weise auf der Außenseite der Kapselung angeordnet werden, bzw. durch entsprechenden Aufbau und Anordnung die Außenseite der Kapsel bilden.

Infolge der zunehmenden Packungsdichte an Elektronik wird das Problem der Wärmeabfuhr von der Leiterplatte - vor allem bei Leistungsstufen - immer aktueller. Eine gleichmäßige Verteilung der Wärme und eine gute Wärmeabfuhr läßt sich durch die Verwendung von sogenannten Metallkernleiterplatten erreichen. Bei diesen Metallkernleiterplatten sind z.B. auf einem Aluminiumblech von z.B. 1 mm Stärke als Metallkern beidseitig isolierende Epoxidharzschichten von z.B. 0,2 bis 0,3 mm aufgebracht, auf denen die Leiterbahnen liegen und die elektronischen Bauelemente angeordnet sind. Bei der bekannten Anordnung nach der US-PS 32 68 772 liegen jeweils Zunge und elektrische Verbindung auf entgegengesetzten Stirnseiten der Metallkernleiterplatte. Die elektrische Verbindung zu den Leiterbahnen wird durch Löten hergestellt. Der Austausch von Leiterplatten ist daher relativ schwierig.

Die Aufgabe der vorliegenden Erfindung besteht darin, bei einem Steuergerät der eingangs genannten Art für eine leichte Austauschbarkeit der Metallkernleiterplatten zu sorgen, worunter aber die Zuverlässigkeit der elektrischen Verbindungen und die Wärmeabfuhr nicht leiden sollen.

Diese Aufgabe wird erfindungsgemäß dadurch gelöst, daß die elektrischen Verbindungen durch eine Steckverbindung hergestellt sind und die Zunge auf der gleichen Seite der Metallkernleiterplatte wie die Steckverbindung liegt und diese überragt und daßbeim Einstecken der Metallkernleiterplatte gleichzeitig die elektrische und die thermische Verbindung hergestellt werden.

Hierdurch können relativ einfach und zuverlässig Leiterplatten ausgetauscht oder zusätzliche Leiterplatten in das Gerät eingesetzt werden. Der für die mechanische Klemmung aufzuwendende Druck sollte dabei etwa dem für die Herstellung der elektrischen Steckverbindung aufzuwendenden Druck entsprechen, um ein Verkanten möglichst zu vermeiden.

Konstruktiv besteht die Klemmvorrichtung vorteilhafterweise aus zwei die Zunge zwischen sich mit definiertem Druck aufnehmenden Klemmbacken, die über eine Bodenplatte mit der Tragprofilplatte verbunden sind. Zur Erleichterung der Einführung der Platte können dabei die Klemmbacken mit einer keilförmigen Einführungsnut versehen sein.

Besonders einfach läßt sich die Klemmvorrichtung herstellen, wenn eine Klemmbacke und die Bodenplatte durch Seiten- und Querteil eines U-Profilstückes gebildet sind und die zweite Klemmbacke über eine Feder oder dergleichen gegen das andere Seitenteil des U-Profilstückes abgestützt ist.

Ein weiterer wichtiger Gesichtspunkt der vorliegenden Erfindung ist darin zu sehen, daß über die Klemmvorrichtung auf sehr einfache Weise die Metallkernplatte auf beliebiges Potential z.B. auf Massepotential gelegt werden kann, wenn die Tragplatte auch an das entsprechende Potential angeschlossen ist. Auf diese Weise steht infolge des großen Querschnittes innerhalb der Leiterplatte an jedem Punkt ein genau definiertes Massepotential zur Verfügung, was aus Gründen der elektrischen Störsicherheit von großer Bedeutung sein kann.

Da durch die vorstehend beschriebene Konstruktion in jedem Fall für eine ausreichende Wärmeabfuhr gesorgt werden kann, normalerweise wird ein Verhältnis von Zungenfläche zur Leiterplattenfläche von 1:20 genügen, kann auch bei gegebenenfalls gekapselten Leiterplatten eine sehr gute Wärmeabfuhr und damit eine hohe Packungsdichte erreicht werden.

Anhand eines in der Zeichnung dargestellten Ausführungsbeispiels sei die Erfindung näher erläutert; es zeigen:

Figur 1 das Prinzipbild des mechanischen Aufbaus des Steuergerätes,

Figur 2 eine Vergrößerung der Einsteckstelle der Leiterplatte in Figur 1 und

Figur 3 die zur Wärmekontaktierung dienende Klemmvorrichtung.

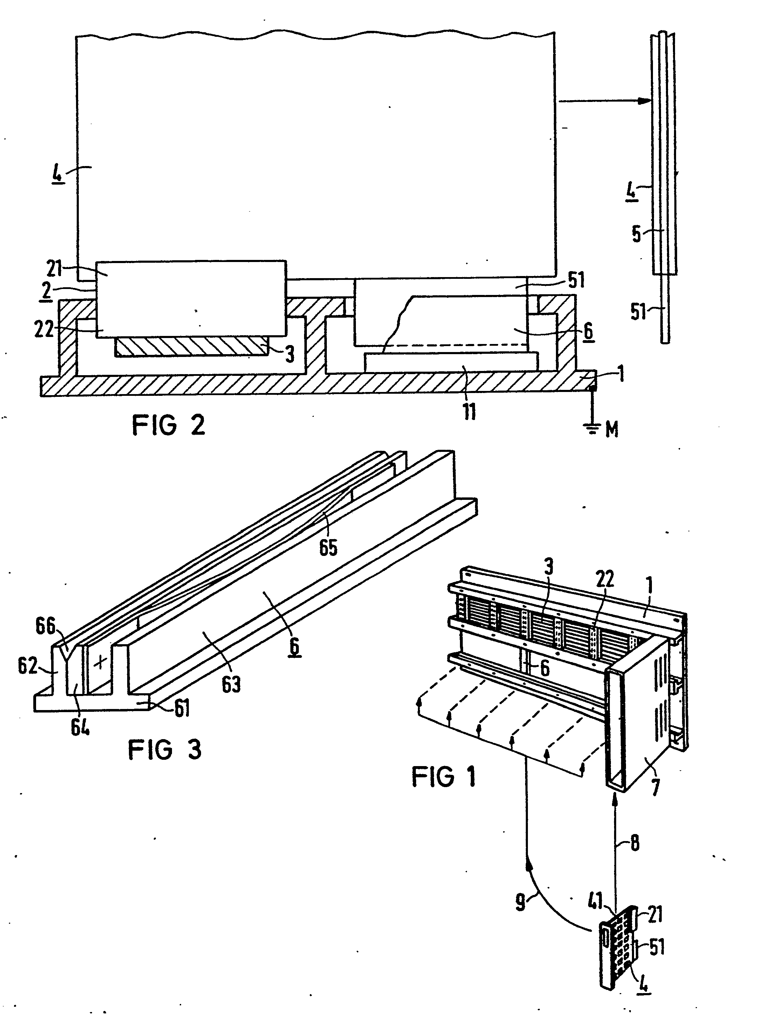

Wie aus Figur 1 ersichtlich, ist auf einer metallischen, z.B. aus Aluminium bestehenden Tragprofilplatte 1 eine Reihe von elektrischen Steckplätzen 22 vorgesehen, die über eine elektrische Busverbindung 3 miteinander in Verbindung stehen. Jedem der sechs dargestellten Einbauplätze ist eine zur Abschirmung bzw. zum mechanischen Schutz dienende Metallkapsel 7 zugeordnet, in die die Leiterplatte 4 eingeschoben wird - Pfeil 8. Beim Einschieben der Leiterplatte wird zwischen dem Steckplatz 22 und dem Steckerteil 21 an der die Elektronik 41 tragenden Leiterplatte 4 die elektrische Steckverbindung 2 hergestellt.

In gleicher Weise sind - wie durch den Pfeil 9 angedeutet - die übrigen Steckerplätze zu besetzen.

Zusätzlich zu den Steckerplätzen 2 sind in einer zweiten freien Reihe der Tragprofilplatte 1 parallel zu den Steckplätzen 22 Klemmvorrichtungen 6 der in Figur 3 näher beschriebenen Art vorgesehen. Beim Einschieben der Leiterplatte 4 wird gleichzeitig neben der elektrischen Steckverbindung 2 eine die Wärme ableitende Steckverbindung zwischen einer Zunge 51 der Leiterplatte 4 und der Klemmvorrichtung 6 geschaffen: Die Zunge 51 wird dabei dadurch gebildet, daß die Metallplatte 5 der als Metallkernleiterplatte ausgebildeten Leiterplatte 4 an dieser Stelle zungenartig aus der Leiterplatte 4 hervorragt. Diese Zunge 51 schiebt infolge der keilförmigen Nut 66 beim Einschieben die beiden Backen 62 und 64 der Klemmvorrichtung 6 gegen die Wirkung der Blattfeder 65 auseinander und wird dann von dem Klemmbacken 62 und 64 flächig und mit definiertem Druck gehalten. Konstruktiv wird dabei die Klemmvorrichtung 6 vorteilhafterweise im wesentlichen aus einem U-Profil mit Bodenteil 61 und Seitenteilen 62 (Klemmbacke) und 63 gebildet. Diese Klemmvorrichtung 6 weist dann infolge der innigen metallischen Berührung zwischen Bodenplatte 61 und entsprechendem Teil 11 der Tragprofilplatte 1 eine große und ausreichende Wärmeübergangsstelle auf, so daß die in der Leiterplatte 4 entstehende Verlustwärme sehr gut zur Tragprofilplatte 1 abgeführt werden kann. Zur Erhöhung der Wärmeleitfähigkeit kann dabei auch noch zusätzlich eine Wärmeleitpaste verwendet werden. Falls die Tragprofilplatte 1 auf elektrisches Massepotential M gelegt wird, ist dieses Massepotential über die Klemmvorrichtung 6 und die Zunge 51 gleichzeitig auch auf die Metallplatte 5 übertragbar, so daß innerhalb der Leiterplatte 4 an jeder Stelle genau definiertes Massepotential zur Verfügung steht.

**Patentansprüche**

1. Steuergerät in Modulbauweise mit Vorrichtungen zur Kühlung von die elektronischen Bauteile tragenden Metallkernleiterplatten (4), bei denen die Bauteile über elektrische Verbindungen mit einem auf einer Tragprofilplatte (1) angeordneten elektrischen Leitungssystem (3) verbindbar sind, der Kern als Zunge (51) aus der Metallkernleiterplatte (4) herausragt und diese Zunge (51) zur Herstellung einer thermischen Verbindung in eine metallische, gut wärmeleitende Klemmvorrichtung (6) steckbar ist, die ihrerseits auf der metallischen Tragprofilplatte (1) angeordnet ist, dadurch gekennzeichnet, daß die elektrischen Verbindungen durch eine Steckverbindung (2) hergestellt sind und die Zunge (51) auf der gleichen Seite der Metallkernleiterplatte (4) wie die Steckverbindung (2) liegt und diese überragt und daß beim Einstecken der Metallkernleiterplatte (4) gleichzeitig die elektrische und die thermische Verbindung (2, 6) hergestellt werden.

2. Steuergerät nach Anspruch 1, dadurch gekennzeichnet, daß die Klemmvorrichtung (6) aus zwei die Zunge (51) zwischen sich mit definiertem Druck aufnehmenden flächigen Klemmbacken (62, 64) besteht, die über eine Bodenplatte (61) flächig mit der gleichzeitig die Steckverbindung tragenden metallischen Tragprofilplatte (1) verbunden sind.

3. Steuergerät nach Anspruch 2, dadurch gekennzeichnet, daß eine Klemmbacke (62) und die Bodenplatte (61) durch Seiten- und Querteile eines U-Profilziehteiles gebildet sind und die zweite Klemmbacke (64) federnd gegen das andere Seitenteil (67) abgestützt ist.

4. Steuergerät nach Anspruch 2, dadurch gekennzeichnet, daß die Klemmbacken (62, 64) mit einer zur Einführung der Zunge (51) dienenden keilförmigen Einführungsnut (66) versehen sind.

5. Steuergerät nach Anspruch 1, dadurch gekennzeichnet, daß der Kern (5) der Metallkernleiterplatte (4) über die Klemmvorrichtung (6) und die Tragprofilplatte (1) mit elektrischem Massepotential (M) verbindbar ist.

**Claims**

1. Modular control apparatus comprising devices for the cooling of metal core circuit boards (4) which carry the electronic components and in which the components can be connected by electrical connections to an electrical conductor system (3) arranged on a profiled carrier plate (1), in which the core extends in the form of a tongue (51) from the metal core circuit board (4), and in which, for the establishment of a thermal connection, this tongue (51) can be plugged into a metallic, good thermally conducting clamping device (6) which is itself arranged on the metallic profiled carrier plate (1), characterised in that the electrical connections are established by means of a plug connection (2) and the tongue (51) is located on the same side of the metal core circuit board (4) as the plug connection (2) and projects beyond the plug connection; and that the electrical and thermal connections (2, 6) are established simultaneously with the plugging in of the metal core circuit board (4).

2. Control apparatus as claimed in Claim 1, characterised in that the clamping device (6) consists of two flat clamping jaws (62, 64) which grip the tongue (51) between them under a predetermined pressure and which are connected by way of a base plate (61) in flat manner to the metallic profiled carrier plate (1) which simultaneously carries the plug connection.

3. Control device as claimed in Claim 2, characterised in that one clamping jaw (62) and the base plate (61) are formed by side and transverse parts of a U-profile drawn member and the second clamping jaw (64) is spring-supported against the other side part (67).

4. Control apparatus as claimed in Claim 2, characterised in that the clamping jaws (62, 64) are provided with a tapered insertion groove (66) into which the tongue (51) is inserted.

5. Control apparatus as claimed in Claim 1, characterised in that the core (5) of the metal core circuit board (4) can be connected to earth potential (M) through the clamping device (6) and the profiled carrier plate (1).

## Revendications

1. Appareil de commande de construction modulaire comportant des dispositifs pour refroidir des plaquettes à circuits imprimés (4) à noyau métallique, portant les composants électroniques et dans lesquelles les composants peuvent être reliés par l'intermédiaire de liaisons électriques à un systéme de conducteurs électriques (3) disposé sur une plaque profilée de support (1), le noyau ressort à la manière d'une languette (51) hors de la plaquette à circuits imprimés (4) à noyau metallique et cette. languette (5l) peut être enfichée, en vue de l'établissement d'une liaison thermique, dans un dispositif métallique de serrage (6) bon conducteur thermique, qui est disposé pour sa part sur la plaque profilée de support métallique (1), caractérisé par le fait que les liaisons électriques sont établies au moyen d'une liaison à enfichage (2) et que la languette (51) est située du même côté de la plaquette à circuits imprimés (4) à noyau métallique que la liaison à enfichage (2) et est en saillie par rapport à cette plaquette, et que la liaison électrique et la liaison thermique (2, 6) sont établies simultanément lors de l'enfichage de la plaquette à circuits imprimés (4) à noyau métallique.

2. Appareil de commande suivant la revendication 1, caractérisé par le fait que le dispositif de serrage (6) est constitué par deux mâchoires de serrage d'une certaine surface (62, 64) qui logent entre elles la languette (51), avec l'application d'une pression définie et qui sont reliées, sur une certaine étendue, par l'intermédimire d'une plaque de base (61) à la plaque profilée de support métallique (1) portant simultanément la liaison à enfichage.

3. Appareil de commande suivant la revendication 2, caractérisé par le fait qu'une mâchoire de serrage (62) et la plaque de base (61) sont formées par un élément latéral et un élément transversal d'une pièce emboutie à profil en U et que la seconde mâchoire de serrage (64) est en appui élastiquement contre l'autre élément latéral (67).

4. Appareil de commande suivant la revendication 2, caractérisé par le fait que les mâchoires de serrage (62, 64) sont munis d'une rainure d'insertion (66) en forme de coin qui sert à l'introduction de la languette (51).

5. Appareil de commande suivant la revendication 1, caractérisé par le fait que le noyau (5) de la plaquette à circuits imprimés (4) à noyau métallique peut être relié par l'intermédiaire du dispositif de serrage (6) et de la plaque profilée de support (1) au potentiel de masse électrique (M).

FIG 2

FIG 3

FIG 1